# EUROPÄISCHE PATENTSCHRIFT

(11) **EP 0 631 393 B1**
(45) Veröffentlichungstag und Bekanntmachung des Hinweises auf die Patenterteilung: **16.08.2001**
(21) Anmeldenummer: 94107408.0
(22) Anmeldetag: 13.05.1994
(51) Int. Cl.: H03M 1/14, H03M 1/48, H03M 3/02

(54) **Abtast-Analog-zu-Digital-Umsetzer mit Gross-Feinbereichs-Architektur und interpolierender Residuums-Kodierung**
Sampling AD converter with coarse/fine range architecture and interpolating residue coding
Convertisseur analogique-numérique à échantillonage à architecture comportant des plages grosses et fines et à codage des résidus par interpolation

(30) Priorität: 19.05.1993 DE 4316910
(43) Veröffentlichungstag der Anmeldung: 28.12.1994
(73) Patentinhaber: FORSCHUNGSZENTRUM JÜLICH GMBH, 52425 Jülich (DE)
(72) Erfinder: Gast, Werner, Dr., D-50939 Köln (DE); Georgiev, Andrey, Dr., D-52382 Niederzier (DE); Lieder, Rainer M., Prof., D-52428 Jülich (DE)

(56) Entgegenhaltungen:
- EP-A- 0 104 689
- DE-A- 3 229 409
- US-A- 3 646 586

## Beschreibung

Die vorliegende Erfindung betrifft eine Schaltungsanordnung zur Abtastung von Signalen gemäß dem Oberbegriff des Anspruchs 1.

Eine solche Schaltungsanordnung ist aus EP 0 104 689 A1 bekannt. In der Schaltungsanordnung des Standes der Technik sollen Bildsignale verarbeitet werden. Dazu ist es erforderlich, im Falle des Auftretens von plötzlichen Sprüngen mit einer Verarbeitung eines Grobbereichs eines Eingangssignals vorlieb zu nehmen. Im Normalbetrieb erfolgt ausschließlich eine Feineinstellung. Dies hat zur Folge, daß, im Falle von plötzlichen Sprüngen, auf die Genauigkeit eines zu verarbeitenden Eingangssignals verzichtet wird. In anderen Anwendungsbereichen, wie z. B. der Verarbeitung von Signalen in der Kernspektroskopie, ist dies von Nachteil.

Die Abtastung von in Halbleiterdetektoren erzeugten Signalen findet in spektroskopischen Systemen statt, die zur Messung der Energie einzelner Strahlungsquanten vorgesehen sind. Durch die Abtastung werden die Signale in ihre digitale Darstellung konvertiert, mit dem Ziel, ihre anschließende digitale Verarbeitung zu ermöglichen.

Das Anwendungsgebiet von Halbleiterspektrometersystemen ist sehr breit und reicht von Meßsystemen für Umweltschutz, Medizin und Materialforschung bis hin zur experimentellen Großprojekten in kernphysikalischer und kosmologischer Grundlagenforschung.

Das Abtasten von Halbleiterdetektorsignalen kann mit Hilfe von Parallelumsetzern (Flash-ADC) erfolgen. Letztere sind zwar hinsichtlich der erreichbaren Abtastraten schnell genug, weisen jedoch eine begrenzte Auflösung, geringe Genauigkeit und hohe differentielle Nichtlinearität auf.

Die Abtastung kann auch mit Umsetzer, die nach dem binären Wägeverfahren ("successive approximation") arbeiten, erfolgen. Sie weisen eine höhere Genauigkeit auf, sind jedoch hinsichtlich der erreichbaren Abtastraten zu langsam, da sie viele binäre Wägeschritte benötigen, um die Wandlung durchzuführen.

Um die Wandlungszeit zu verbessern, können nach dem Zweischrittverfahren mit Grob-Feinbereichs-Architektur ("subranging principle") arbeitende Umsetzer eingesetzt werden. Bei ihnen wird die Wandlung in einen Grob- und einen Feinbereich unterteilt. Das Eingangssignal wird zunächst von einem schnellen Parallelumsetzer digitalisiert, der einen Grobwert des Eingangssignals liefert. Dieser Grobwert wird als höher wertiger Anteil (MSB: Most Significant Bits) des digitalen Endergebnisses gespeichert und gleichzeitig mit Hilfe eines Digital-zu-Analog-Umsetzers in ein analoges Signal zurückverwandelt. In einem zweiten Schritt wird das analoge Restwertsignal (Residuum) als Differenz zwischen dem Eingangssignal und seinem analogen Grobwert gebildet. Dieses Restwertsignal wird verstärkt und von einem zweiten Parallelumsetzer wiederum digitalisiert. Auf diese Weise erhält man den Feinwert, d. h. den niederwertigeren Anteil (LSB: Least Significant Bits) des Endergebnisses. Die anschließende Kombination beider Anteile ergibt schließlich das vollständige, digitale Endergebnis. Dieses Verfahren ist schneller als das binäre Wägeverfahren. Allerdings ist auch hier die Auflösung begrenzt, und wegen der bei der Bildung und Wandlung des Restwertsignals auftretenden Fehler ist die Genauigkeit in der Regel nicht ausreichend, um Halbleiterdetektorsignale präzise genug abzutasten. Zudem führen die Schwierigkeiten beim exakten Abgleich der beiden Bereiche zu unbefriedigenden differentiellen Nichtlinearitäten.

Die Aufgabe der vorliegenden Erfindung ist, eine Schaltungsanordnung für die Abtastung statistisch auftretender Halbleiter Detektorsignale zu schaffen, die eine hohe Abtastrate, das heißt, kurze Wandlungszeit, und eine im Vergleich zu den in der Schaltung eingesetzten Parallelumsetzern höhere Auflösung und Genauigkeit sowie einen größeren dynamischen Bereich und eine geringere differentielle Nichtlinearität aufweist.

Diese Aufgabe wird durch die Schaltungsanordnung durch die kennzeichnenden Merkmale des Anspruchs 1 gelöst.

Um diese Ziele zu erreichen, wird für die Abtast-Analog-zu-Digital-Umsetzung eine Grob-Feinbereichs-Architektur mit interpolierender Residuums-Kodierung verwendet. Den Grobwert ermittelt man durch digitale Integration des von einem differenzierenden Analog-zu-Digital-Umsetzer abgetasteten Eingangssignals. Auf diese Weise erhält man einen digital rekonstruierten Grobwert des originalen, nicht differenzierten Eingangssignals. Dieser Grobwert wird anschließend von einem Digital-zu-Analog-Umsetzer in ein analoges Signal zurückgewandelt und mit Hilfe eines analogen Subtrahierers vom Eingangssignal subtrahiert. Auf diese Weise wird das Restwertsignal (Residuum) ermittelt. Dieses Signal wird wiederum mit Hilfe eines Analog-zu-Digital-Umsetzers digitalisiert und das Resultat von einem Summierer zum Grobwert im Integrator hinzuaddiert.

Weitere Vorteile der vorliegenden Erfindung ergeben sich aus den Merkmalen der Unteransprüche 2 bis 4.

Eine Ausführungsform der vorliegenden Erfindung wird im folgenden anhand der schematischen Zeichnung näher beschrieben.

Das Eingangssignal 9 wird zunächst mit Hilfe eines differenzierenden Analog-zu-Digital-Umsetzers 1 digitalisiert, und der resultierende Digitalwert über den Summierer 3 in den Integrator 4 eingespeist. Zur Vermeidung von Aliasing-Effekten durch hochfrequente Signal-oder Rauschanteile kann bei Bedarf ein Tiefpaß-Filter 7 eingesetzt werden, das zwischen den Eingang 9 der Schaltungsanordnung und den differenzierenden Analog-zu-Digital-Umsetzer zu schalten ist. Der Ausgangswert des Integrators wird mit Hilfe eines Digital-zu-Analog-Umsetzers 5 in ein analoges Signal 10 zurückgewandelt. Dieses Signal wird von einem analogen Subtrahierer 6 vom Eingangssignal subtrahiert. Die Verzögerung in der Rückkopplungsschleife, die durch den Parallelumsetzer 2, den Summierer 3, den Integrator 4, den Digital-zu-Analog-Umsetzer 5 und den analogen Subtrahierer 6 gebildet wird, kann durch die Verzögerungseinheit 8 kompensiert werden. Diese Einheit ist zwischen den Eingang des differenzierenden Analog-zu-Digital-Umsetzers 1 und den positiven Eingang des analogen Subtrahierers 6 zu schalten. Das Ausgangssignal des analogen Subtrahierers 6 stellt das Restwertsignal (Residuum) dar, das dann mit Hilfe eines zweiten Analog-zu-Digital-Umsetzers 2 digitalisiert wird. Das digitale Ergebnis wird über den Summierer 3 in den Integrator 4 eingespeist. Auf diese Weise werden die Grobwerte und die Restwerte vom Summierer 3 addiert und im Integrator 4 akkumuliert. Der Ausgang des Integrators stellt gleichzeitig den Ausgang der Schaltungsanordnung dar. Die resultierenden Ausgangswerte zeichnen sich im Vergleich zu den intern Verwendung findenden Wandlern 1 und 2 durch eine höhere Auflösung und Genauigkeit, eine geringere differentielle Nichtlinearität und einen größeren dynamischen Bereich aus. Jeder verbleibende Fehler ergibt einen Unterschied zwischen dem Eingangssignal und dem in ein analoges Signal zurückverwandelten Ausgangswert. Dieser Fehler wird vom Parallelumsetzer 2 wieder digitalisiert und über den Summierer 3 zum Integrator 4 addiert. Auf diese Weise werden die von den Unzulänglichkeiten der internen Komponenten (Wandler und analoger Subtrahierer) verursachten Fehler kompensiert.

Um den differenzierenden Anlalog-zu-Digital-Umsetzer aufzubauen, werden zweckmäßigerweise gebräuchliche Elektronikbauelemente verwendet. Dies sind ein analoger Diffentiator und ein Analog-zu-Digital-Umsetzer (ADC). Der Eingang des analogen Differentiators stellt gleichzeitig den Eingang des differenzierenden Analog-zu-Digital-Umsetzers dar. Der Ausgang des ADC's ist gleichzeitig der Ausgang des differenzierenden Analog-zu-Digital-Umsetzers. Der Ausgang des analogen Differentiators ist mit dem Eingang des ADC's verbunden.

Als ADC kann für den differenzierenden Analog-zu-Digital-Umsetzer ein Flash-ADC eingesetzt werden.

Als ADC zur Digitalisierung des analogen Restwertsignals, das sich als Differenz zwischen dem Eingangssignal und dem digital rekonstruierten und in ein analoges Signal rückgewandeltes Eingangssignal ergibt, kann ein Flash-ADC verwendet werden.

Als analoger Subtrahierer kann ein Differenzverstärker benutzt werden. Als digitaler Integrator kann ein digitaler Akkumulator eingesetzt werden.

Der Akkumulator kann unter Verwendung gebräuchlicher Elektronikbauelemente aufgebaut werden. Letztere sind ein Summierer und ein Register. Der erste Eingang des Summierers stellt den Eingang des Akkumulators dar. Der zweite Eingang des Summierers ist mit dem Ausgang des Registers verbunden, wobei letzterer gleichzeitig den Ausgang des Akkumulators darstellt. Der Eingang des Registers ist mit dem Ausgang des Summierers verschaltet.

Anstelle der digitalen Integration des differenzierten und abgetasteten Eingangssignals kann eine digitale Tiefpaß-Filterung derselben durchgeführt werden. Folglich kann anstelle des digitalen Integrators ein digitaler Tiefpaß verwendet werden.

Anstelle der Differentiation des Eingangssignals kann eine Hochpaß-Filterung derselben erfolgen, so daß anstelle des analogen Differentiators ein Hochpaß-Filter eingesetzt werden kann.

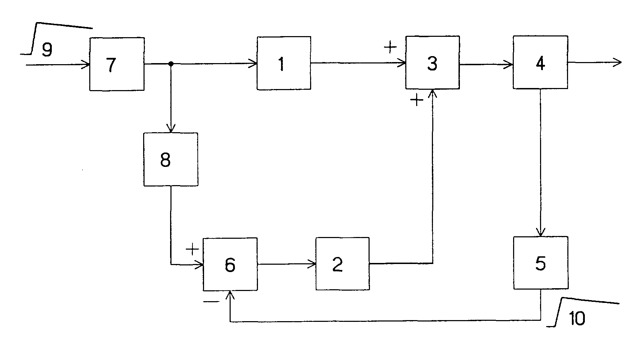

## Patentansprüche

1. Schaltungsanordnung zur Abtastung statistisch auftretender Signale, speziell solcher mit steilem Anstieg und langsamem Abfall, wie sie in der Kernspektroskopie mit Halbleiterdetektoren häufig anzutreffen sind,
- mit einem Eingang für ein analoges Eingangssignal (9);
- mit einem ersten A/D-Umsetzer (1) zur Digitalisierung des Eingangssignals (9);
- mit einem D/A-Umsetzer (5) zur Umsetzung des digitalisierten Eingangssignals in ein analoges Zwischensignal (10);
- mit einem Subtrahierer (6) zur Feststellung einer Signaldifferenz (Residuum) zwischen dem analogen Eingangssignal (9) und dem analogen Zwischensignal (10);
- mit einem zweiten A/D-Umsetzer (2) zur Digitalisierung der Signaldifferenz;
- mit einer Einrichtung zum Summieren (3) der digitalisierten Signaldifferenz zu dem digitalisierten Eingangssignal, und
- mit einem Ausgang für ein digitales Ausgangssignal, das der Summe aus dem digitalisierten Eingangssignal und der digitalisierten Signaldifferenz entspricht;
**dadurch gekennzeichnet,**
- daß der erste A/D-Umsetzer (1) ein differenzierender Umsetzer ist, wobei der erste A/D Umsetzer (1) eine geringere Auflösung als der D/A-Umsetzer (5) hat,
- daß dem ersten A/D-Umsetzer (1) ein Integrator (4) zur digitalen Integration der in der Einrichtung zum Summieren (3) erzeugten Summe aus dem digitalisierten Eingangssignal und der digitalisierten Signaldifferenz nachgeordnet ist, wobei das digitalisierte und integrierte Ausgangssignal des Integrators (4) eine höhere Auflösung und einen größeren dynamischen Bereich im Vergleich zum ersten und zweiten A/D-Umsetzer (1, 2) aufweist, und
- daß der erste A/D-Umsetzer (1) und der zweite A/D-Umsetzer (2) bei gleicher Abtastfrequenz arbeiten.

2. Schaltungsanordnung nach Anspruch 1,
**dadurch gekennzeichnet,**
daß der Subtrahierer (6) ein Differenzverstärker ist.

3. Schaltungsanordnung nach Anspruch 1 oder 2,
**dadurch gekennzeichnet,**
daß der Integrator (4) ein Akkumulator ist.

4. Schaltungsanordnung nach einem der Ansprüche 1 bis 3,
**dadurch gekennzeichnet,**
daß zur Kompensation einer Verzögerung einer durch den zweiten A/D-Umsetzer (2), die Einrichtung zum Summieren (3), den Integrator (4), den D/A-Umsetzer (5) und dem Subtrahierer (6) gebildeten Rückkopplungsschleife eine Verzögerungseinheit (8) zwischen dem Eingang des ersten A/D-Umsetzers (1) und einem positiven Eingang des Subtrahierers (6) eingesetzt ist.

## Claims

1. Circuit arrangement for scanning statistically occurring signals, specifically those with a steep build-up and a slow decay, of the type frequently encountered in nuclear spectroscopy with semiconductor detectors, having
- a first input for an analogue input signal (9);
- a first A/D converter (1) for digitising the input signal (9);
- a D/A converter (5) for converting the digitised input signal to an analogue intermediate signal (10);
- a subtractor (6) for ascertaining a signal differential (residue) between the analogue input signal (9) and the analogue intermediate signal (10);
- a second A/D converter (2) for digitising the signal differential;
- a system for totalising (3) the digitised signal differential onto the digitised input signal, and
- an output for a digitised output signal that corresponds to the sum of the digitised input signal and the digitised signal differential;
characterised in that
- the first A/D converter (1) is a differentiating converter, the first A/D converter (1) having a lesser resolution than the D/A converter (5),
- arranged after the first A/D converter (1) is an integrator (4) for the digital integration of the total generated in the totalising system (3) from the digitised input signal and the digitised signal differential, the digitised and integrated output signal from the integrator (4) having a higher resolution and a greater dynamic range compared to the first and second A/D converter (1, 2), and
- the first A/D converter (1) and the second A/D converter (2) operate at the same scanning frequency.

2. Circuit arrangement according to claim 1,
characterised in that the subtractor (6) is a differential amplifier.

3. Circuit arrangement according to claim 1 or 2,
characterised in that the integrator (4) is an accumulator.

4. Circuit arrangement according to any of claims 1 to 3,
characterised in that to compensate for a delay in a feedback loop constituted by the second A/D converter (2), the totalising system (3), the integrator (4), the D/A converter (5) and the subtractor (6), a time-delay unit (8) is inserted between the input of the first A/D converter (1) and a positive input of the subtractor (6).

## Revendications

1. Montage pour échantillonner des signaux apparaissant statistiquement, particulièrement des signaux à croissance à grande pente et à décroissance lente, tels qu'il s'en trouve souvent dans la spectroscopie nucléaire par détecteurs à semiconducteurs,
- comportant une entrée pour un signal (9) d'entrée analogique,
- comportant un premier convertisseur (1) A/N pour la numérisation du signal (9) d'entrée ;
- comportant un convertisseur (5) N/A pour la conversion du signal d'entrée numérisé en un signal (10) intermédiaire analogique ;
- comportant un soustracteur (6) pour constater une différence de signal (résidu) entre le signal (9) d'entrée analogique et le signal (10) intermédiaire analogique ;
- comportant un deuxième convertisseur (2) A/N pour numériser la différence de signal ;
- comportant un dispositif pour faire la somme (3) de la différence de signal numérisé et du signal d'entrée numérisé, et
- comportant une sortie pour un signal de sortie numérique qui correspond à la somme du signal d'entrée numérisé et de la différence de signal numérisé ;
caractérisé
- en ce que le premier convertisseur (1) A/N est un convertisseur différenciateur, le premier convertisseur (1) A/N ayant une résolution plus petite que le convertisseur (5) N/A,
- en ce qu'il est monté en aval du premier convertisseur (1) A/N un intégrateur (4) pour l'intégration numérique de la somme produite dans le dispositif sommateur (3) du signal d'entrée numérisé et de la différence de signal numérisé, le signal de sortie numérisé et intégré de l'intégrateur (4) ayant une résolution plus grande et une plage dynamique plus grande que celles du premier et du deuxième convertisseurs (1, 2) A/N, et
- en ce que le premier convertisseur (1) A/N et le deuxième convertisseur (2) A/N travaillent à la même fréquence d'échantillonnage.

2. Montage suivant la revendication 1, caractérisé en ce que le soustracteur (6) est un amplificateur différentiel.

3. Montage suivant la revendication 1 ou 2, caractérisé en ce que l'intégrateur (4) est un accumulateur.

4. Montage suivant l'une des revendications 1 à 3, caractérisé en ce que, pour compenser un retard d'une boucle de rétrocouplage formée par le deuxième convertisseur (2) A/N, le dispositif pour sommer (3), l'intégrateur (4), le convertisseur (5) N/A et le soustracteur (6), une unité (8) de temporisation est insérée entre l'entrée du premier convertisseur (1) A/N et une entrée positive du soustracteur (6).
